# EUROPÄISCHE PATENTSCHRIFT

(11) **EP 3 581 005 B1**
(45) Veröffentlichungstag und Bekanntmachung des Hinweises auf die Patenterteilung: **16.03.2022**
(21) Anmeldenummer: 18703990.4
(22) Anmeldetag: 07.02.2018
(51) Int. Cl.: H05K 7/20

(54) **ELEKTRISCHES GERÄT UND VERFAHREN ZUR HERSTELLUNG EINES ELEKTRISCHEN GERÄTS**
ELECTRIC DEVICE AND METHOD FOR PRODUCING AN ELECTRIC DEVICE
DISPOSITIF ÉLECTRIQUE ET PROCÉDÉ DE FABRICATION D'UN DISPOSITIF ÉLECTRIQUE

(30) Priorität: 11.02.2017 DE 102017001351
(43) Veröffentlichungstag der Anmeldung: 18.12.2019
(73) Patentinhaber: KOSTAL Automobil Elektrik GmbH & Co. KG, 58513 Lüdenscheid (DE)
(72) Erfinder: WESSEL, Sven, 42107 Wuppertal (DE); LENKENHOFF, Christian, 58332 Schwelm (DE); HEES, Norbert, 44139 Dortmund (DE)
(74) Vertreter: Kerkmann, Detlef
(86) Internationale Anmeldenummer: PCT/EP2018/053055
(87) Internationale Veröffentlichungsnummer: WO 2018/146136

(56) Entgegenhaltungen:
- DE-B3-102013 109 589
- US-A- 5 841 634
- US-A1- 2003 053 294

## Beschreibung

Die Erfindung betrifft ein elektrisches Gerät mit einer Leistungselektronik, die in einem Metall-Gehäuse aufgenommen ist, wobei Bauelemente der Leistungselektronik auf einer ersten Hauptfläche eines Schaltungsträgers, bestehend aus einer metallischen Grundplatte und mindestens einer Lage aus strukturiertem leitfähigem Material auf einem Dielektrikum, angeordnet sind, wobei zumindest eine Trennwand des Gehäuses in direktem Kontakt mit einem fluiden Kühlmedium ist, wobei die Trennwand des Gehäuses zumindest teilweise durch den Schaltungsträger gebildet wird, so dass deren zweite, der Bauteilseite gegenüberliegende Hauptfläche in direktem Kontakt mit dem fluiden Kühlmedium ist, und wobei der Schaltungsträger mit dem übrigen Gehäuse durch eine Schweißverbindung fluiddicht verbunden ist, sowie ein Verfahren zur Herstellung eines solchen elektrischen Geräts.

Um die durch die in einer Leistungselektronik entstehende Verlustleistung erzeugte Wärme möglichst effektiv abzuführen, gibt es verschiedene Möglichkeiten. Bei geringen Verlustleistungen reicht es aus, wenn eine die Leistungsbauteile aufnehmende Leiterplatte an ein luft- oder wassergekühltes Gehäuse gedrückt wird. Diese Variante ist aber auf kleine Verlustleistungen begrenzt, da die üblicherweise eingesetzten Leiterplattenmaterialien zum Einen selbst eine geringe Wärmeleitfähigkeit haben - für FR4 z.B. beträgt diese ca. 0,2 W/(m*K) - zum Anderen der Wärmeübergang von der Leiterplatte auf das gekühlte Gehäuse durch leichteste Unebenheiten verschlechtert wird. Die Fläche, die keinen direkten Kontakt zur Gegenfläche hat, und somit ihre Wärme über eine Luftstrecke ableiten muss, wobei Luft eine Wärmeleitfähigkeit von nur ca.0,02 W/(m*K) aufweist, wird über die Zeit einen Temperaturanstieg erfahren, der sowohl die Leiterplatte selbst als auch die darauf liegenden Bauteile beschädigen kann. Eine Verbesserung bringen hier sogenannte Gapfiller oder Gappads. Das sind pastöse bzw. schaumartige Kunststoffe oder Klebestreifen, die nach der Montage einen besseren Wärmeübergang ermöglichen. Derartige Stoffe haben eine Wärmeleitfähigkeit von ca. 2 W/(m*K), sind also um den Faktor 100 besser als Luft.

In den letzten Jahren hat sich insbesondere in der Beleuchtungsindustrie ein neuartiges Verfahren etabliert, bei dem ein ein- oder mehrlagiger Aufbau von Leiterbahnen und darauf angeordneten Bauelementen direkt auf eine Aluminium- oder Kupferplatte laminiert wird, um einen möglichst direkten Wärmeübergang in die Grundplatte zu erzielen. Aluminium hat eine sehr gute Wärmeleitfähigkeit, die mit ca. 220 W/(m*K) angegeben wird, bei Kupfer liegt dieser Wert sogar bei ca. 400 W/(m*K). Dabei wird die Wärme von einem lokalen Hotspot durch die Platte großflächig verteilt. Diese sogenannten IMS-Leiterplatten (Insulated Metal Substrate) zeichnen sich durch ihre besonders gute Wärmeabfuhr aus und halten in immer weiteren Anwendungen der Leistungselektronik Einzug.

Diese Schaltungsträger können auch in die mittlerweile üblichen wassergekühlten Aluminiumdruckgussgehäuse eingesetzt werden, wobei jedoch auch hier nach wie vor die Problematik besteht, einen guten Wärmeübergang von der Aluminiumplatte auf das Gussgehäuse zu erzeugen. Dies geschieht üblicherweise mit Wärmeleitpaste oder -Kleber als Interfacematerial wodurch ein zusätzlicher Wärmeübergang und zusätzliche Kosten entstehen.

Die DE 10 2013 109 589 A1 zeigt ein Leistungshalbleitermodul mit einem Kühlkörper, bei dem eine Schweißnaht eine Kühlplatte mit einem Kühlgehäusebauteil unter Bildung eines Hohlraums verbindet. Der Hohlraum ist zur Kühlung der Leistungshalbleiterbauelemente durch eine Kühlflüssigkeit durchströmbar.

Die US 2003/0053294 A1 zeigt ein elektrisches Gerät gemäß dem Oberbegriff des Patentanspruchs 1. Der Schaltungsträger ist bei diesem Gerät direkt an den Kühlkreislauf angebunden, so dass die Wärme direkt durch die Grundplatte des Schaltungsträgers an das Kühlmedium abgegeben werden kann. In einer Ausführungsform dieses elektrischen Geräts ist der Schaltungsträger mit dem übrigen Gehäuse mittels eines Rührreibschweißverfahrens fluiddicht verbunden.

Das elektrische Gerät gemäß der vorliegenden Erfindung hat gegenüber dem Stand der Technik den Vorteil, besonders einfach und kostengünstig herstellbar zu sein und zudem einen fluiddichten Abschluss des Gehäuses aufzuweisen, der auch den im Kühlkanal in Extremfällen auftretenden Drücken bis etwa 10 bar problemlos standhalten kann.

Dies gelingt bei dem erfindungsgemäßen elektrischen Gerät dadurch, dass das Kühlmedium Wasser ist, das durch einen Kühlkanal, der durch ein zwischen der Trennwand des Gehäuses und einem Deckel angeordnetes Wasserführungselement aus Kunststoff gebildet ist, an dem Gehäuse entlang geführt wird, und dass der Schaltungsträger vor dem Verschweißen von der Wasserseite in eine Öffnung eingelegt ist und dort auf einem umlaufenden Absatz aufliegt.

Das erfindungsgemäße Verfahren zur Herstellung eines solchen elektrischen Geräts, bei dem der Schaltungsträger mit dem übrigen Gehäuse mittels eines Rührreibschweißverfahrens fluiddicht verbunden wird, ist dadurch gekennzeichnet, dass der Schaltungsträger vor der Durchführung des Rührreibschweißverfahrens mit den elektronischen Bauelementen bestückt wird, und dass durch eine Abstützung mit einer guten Wärmeleitung die Prozesswärme des Rührreibschweißverfahrens abseits der Schweißnaht schnell abgeführt wird.

Im Folgenden werden das erfindungsgemäße elektrische Gerät, sowie das zu seiner Herstellung vorgesehene erfindungsgemäße Verfahren anhand eines Ausführungsbeispiels gemäß der Zeichnung näher erläutert.

Die Figuren zeigen dabei:
- Fig. 1:: Eine Ansicht eines Gehäuses eines erfindungsgemäßen elektrischen Geräts
- Fig. 2:: Das Gehäuse aus Fig. 1 in einer anderen Ansicht und ohne das Wasserführungselement
- Fig. 3:: Das Gehäuse aus Fig. 1 im Längsschnitt

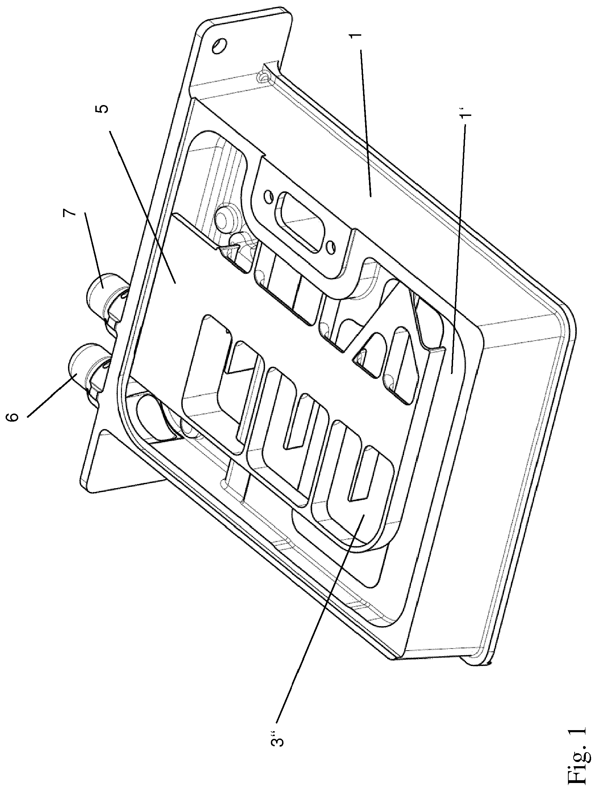

Bei dem in der Zeichnung gezeigten Gehäuse 1 eines erfindungsgemäßen elektrischen Steuergeräts handelt es sich um einen Aluminium-Druckgusskörper. Das Gehäuse 1 ist in der Fig. 1 von seiner "Außenseite" her zu sehen, wobei "Innenseite" bzw. "Innenwand" 1' und "Außenseite" bzw. "Trennwand" 1' in Bezug auf das Gehäuse 1 in dem Sinne gemeint sind, dass sich die elektronischen Bauelemente 2 des Steuergeräts im "Inneren" des Gehäuses 1 befinden, während die Trennwand 1'des Gehäuses 1 in unmittelbarem Kontakt mit dem fluiden Kühlmedium ist. Als Kühlmedium kommt hierbei Wasser zum Einsatz, das in einem Kühlkanal fließend an dem Gehäuse 1 entlang geführt wird. Der Kühlkanal wird durch ein Wasserführungselement 5 gebildet, das zwischen der Trennwand 1' des Gehäuses 1 und einem in der Zeichnung nicht dargestellten Deckel angeordnet ist. Der Deckel wird auf dem oberen Rand des Gehäuses 1 angebracht um den Kühlkanal zu verschließen. Das Kühlwasser wird durch einen Einlassstutzen 6 zugeführt und verlässt den Kühlkanal durch einen Auslassstutzen 7, nachdem es durch den mäanderförmigen Kühlkanal an der Trennwand 1' des Gehäuses 1 vorbeigeflossen ist. Das Wasserführungselement 5 ist als Kunststoffteil ausgeführt, das zwischen der Trennwand 1' des Gehäuses 1 und dem Deckel eingeklemmt wird.

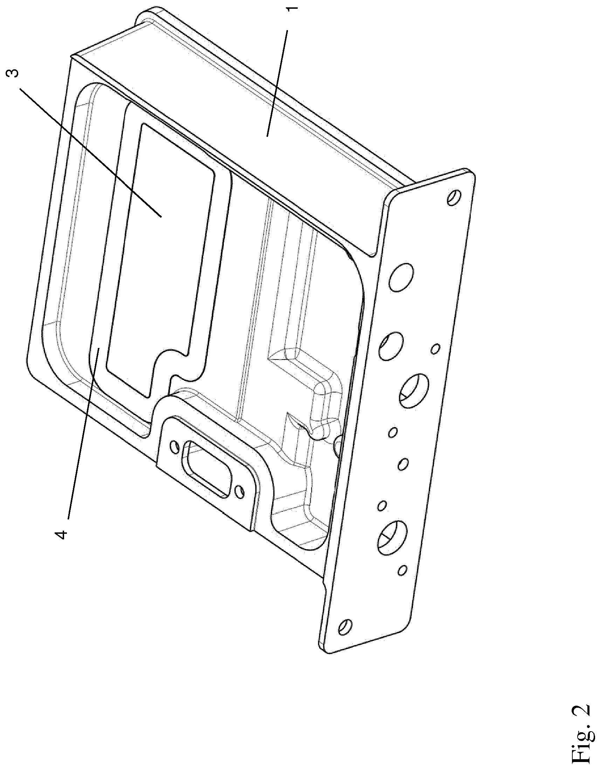

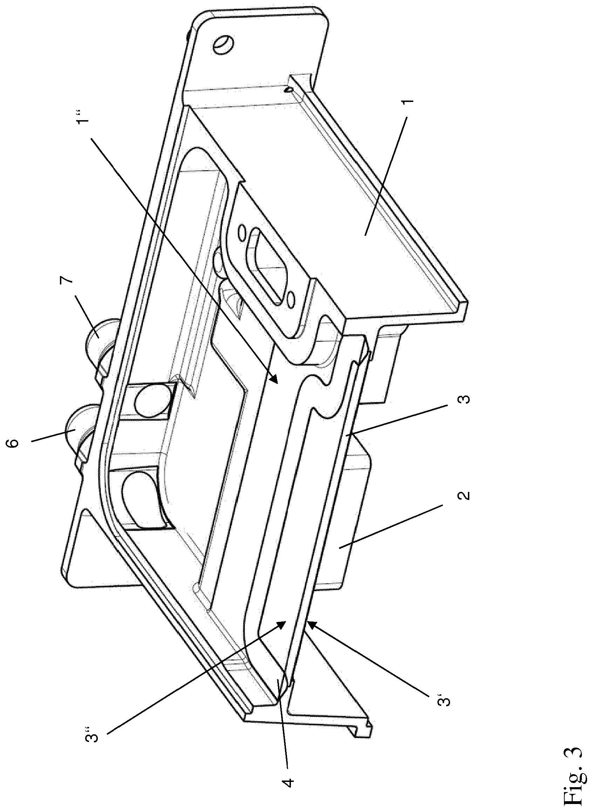

Wie genauer in der Ansicht ohne das Wasserführungselement 5 in Fig. 2 sowie in dem Längsschnitt durch das Gehäuse 1 in Fig. 3 zu sehen ist, wird die Trennwand 1' des Gehäuses 1 zum Teil durch den Schaltungsträger 3 gebildet. Dabei bildet die erste Hauptfläche 3' des Schaltungsträgers 3, die sogenannte Bauteilseite, einen Teil der Innenwand 1' des Gehäuses 1. Diese Bauteilseite ist mit elektrischen Leiterstrukturen versehen, auf denen die elektronischen Bauelemente 2 der Leistungselektronik angeordnet sind. Bei diesen elektronischen Bauelementen 2 handelt es sich insbesondere um Leistungshalbleiter, die im Betrieb des elektrischen Steuergeräts eine starke Wärmeentwicklung aufweisen. Die zweite, der Bauteilseite gegenüberliegende Hauptfläche 3" des Schaltungsträgers 3, bildet einen Teil der Trennwand Wand 1' des Gehäuses 1. Da diese Trennwand Wand 1' in direktem Kontakt mit dem zur Kühlung dienenden Wasser ist, muss der Schaltungsträger 3 mit dem übrigen Gehäuse 1 fluiddicht verbunden sein. Diese fluiddichte Verbindung ist durch die dargestellte Schweißverbindung 4 realisiert, die gemäß dem erfindungsgemäßen Verfahren zur Herstellung des elektrischen Steuergeräts mittels eines Rührreibschweißverfahrens realisiert wird. Wie in Fig. 3 zu sehen, wird der Schaltungsträger 3 vor dem Verschweißen von der Wasserseite in eine Öffnung eingelegt und liegt dort auf einem umlaufenden Absatz auf. Dies hat den Vorteil, dass der Wasserdruck im Kühlkanal nicht die Schweißverbindung belastet. Der Schaltungsträger 3 wird stattdessen sogar, sobald sie von der Wasserseite her mit Druck beaufschlagt wird, gegen den umlaufenden Absatz, also gegen das Gehäuse gedrückt.

Bei der Durchführung des Rührreibschweißverfahrens kann der Schaltungsträger 3 bereits mit den elektronischen Bauelementen 2 bestückt sein. Es ist aber auch möglich, zuerst den unbestückten Schaltungsträger 3 mit dem übrigen Gehäuse 1 zu verschweißen, und die elektronischen Bauelemente 2 erst danach zu bestücken.

Da es sich bei den verwendeten elektronischen Bauelementen 2 um sogenannte SMD Bauelemente handelt, wird die Variante mit dem bereits bestückten Schaltungsträger bevorzugt, da dies eine Verarbeitung in konventionellen Bestückungsautomaten und Lötvorrichtungen ermöglicht. Hierbei besteht jedoch die Problematik, dass bei der Durchführung des Rührreibschweißverfahrens ein nicht unerheblicher Wärmeeintrag in das Material des Schaltungsträgers erfolgt. Die durchaus erwünschte und für die Kühlung des fertigen Steuergeräts auch notwendige, hohe Wärmeleitfähigkeit des Schaltungsträgers 3 erweist sich bei diesem Herstellungsverfahren als momentaner Nachteil, da dabei die elektronischen Bauelemente 2 oder zumindest die Lötstellen derselben Schaden nehmen können.

Beim Schweißen von Aluminium besteht im Allgemeinen das Problem, dass durch die gute Wärmeleitfähigkeit die eingebrachte Wärme schnell abgeführt wird, demnach also nicht lokal eine Stelle aufschmilzt sondern das gesamte Bauteil sehr stark erwärmt wird, bis die Schweißtemperatur überhaupt erreicht wird. Außerdem ist eine Oxidhaut zu durchdringen, die einen höheren Schmelzpunkt als das reine Aluminium hat. Es ist also ein Schweißverfahren notwendig, welches wenig Wärme einbringt und gleichzeitig eine fluiddichte Verbindung erzeugt. Ein solches Verfahren ist das sogenannte Rührreibschweißen, bei dem ein schnell rotierender Rührpin in das Material eintaucht und dabei eine Reibungswärme erzeugt. Die durch diese Reibungswärme erzeugte Temperatur liegt unter dem eigentlichen Schmelzpunkt des Aluminiums, so dass das Aluminium in der Umgebung des Rührpins nicht tatsächlich schmelzflüssig wird, sondern lediglich eine teigige Konsistenz aufweist. Durch Bewegen des Rührpins entlang der Verbindungslinie der zu verschweißenden Gegenstände entsteht bei diesem Verfahren ein sehr feinkörniges Gefüge und eine gasdichte Schweißnaht.

Mit diesem Schweißverfahren wird also relativ wenig Wärme eingebracht und eine gasdichte Verbindung erstellt. Aber auch diese vergleichsweise geringe Temperatur, die lokal bis ca. 550°C betragen kann, ist unter Umständen für die aufgelöteten Bauteile zu hoch, so dass beim Bau der Schweißvorrichtung eine Möglichkeit zur Wärmeabfuhr vorgesehen werden muss. Das wiederspricht zwar dem eigentlichen Bestreben in das Material möglichst schnell Wärme einzubringen um das Material in einen teigigen Zustand zu versetzen, aber durch Anpassung der Schweißparameter ist auch dieses Problem in den Griff zu bekommen. In Bereichen, in denen auch in der Nähe des Randes des Schaltungsträgers Bauteile platziert werden müssen, kann durch eine Abstützung mit einer guten Wärmeabfuhr, beispielsweise durch ein gekühltes Abstützelement, oder auch durch Kontaktblöcke aus Kupfer oder Aluminium die Wärme noch schneller wieder aus dem Material abgeleitet werden, um die Bauteile und deren Lötstellen zu schützen.

Generell ist bei der Verteilung der Bauteile auf dem Schaltungsträger zu beachten, dass Bauteile, die temperaturempfindlich sind, möglichst weit entfernt von der Schweißnaht angeordnet werden.

Die Länge des Rührpins wird so gewählt, dass der Schaltungsträger 3, der vorzugsweise eine Dicke von 2,0 - 3,0 mm hat, zwar sicher verschweißt, jedoch nicht durchdrungen wird.

Das Dielektrikum und die eine oder mehrere Kupferlagen auf der Bauteilseite des Schaltungsträgers 3 können im Bereich der Schweißnaht weggefräst werden. So ist sichergestellt, dass keine Fremdmaterialien in die Schweißnaht eingearbeitet werden. Da für die Leiterplattenbearbeitung in der Regel aber relativ kleine Fräser zum Einsatz kommen, würde ein solches Vorgehen hier sehr lange Fräszeiten mit sich bringen, insbesondere, wenn das Dielektrikum komplett freigestellt werden müsste. Es hat sich indes gezeigt, dass die dünne Leiterplattenschicht auch auf dem Schaltungsträger 3 belassen werden kann. Es ist lediglich eine elektrische Trennung zwischen dem Schaltungsteil und den Randbereichen vorzusehen, um die Potentiale von Leiterplatte und Gehäuse zu trennen. Dies ist kostenneutral im Herstellungsprozess des Schaltungsträgers möglich z.B. beim Ätzen der Leiterstrukturen. Die dünne Schicht beeinflusst den Schweißprozess nicht in relevantem Maße.

## Patentansprüche

1. Elektrisches Gerät mit einer Leistungselektronik, die in einem Metall-Gehäuse (1) aufgenommen ist, wobei Bauelemente der Leistungselektronik (2) auf einer ersten Hauptfläche (3') eines Schaltungsträgers, bestehend aus einer metallischen Grundplatte und mindestens einer Lage aus strukturiertem leitfähigem Material auf einem Dielektrikum, angeordnet sind, wobei zumindest eine Trennwand (1') des Gehäuses (1) in direktem Kontakt mit einem fluiden Kühlmedium ist, wobei die Trennwand (1') des Gehäuses (1) zumindest teilweise durch den Schaltungsträger (3) gebildet wird, so dass deren zweite, der Bauteilseite (3') gegenüberliegende Hauptfläche (3") in direktem Kontakt mit dem fluiden Kühlmedium ist, und wobei der Schaltungsträger (3) mit dem übrigen Gehäuse (1) durch eine Schweißverbindung (4) fluiddicht verbunden ist, **dadurch gekennzeichnet, dass** das Kühlmedium Wasser ist, das durch einen Kühlkanal, der durch ein zwischen der Trennwand (1') des Gehäuses (1) und einem Deckel angeordnetes Wasserführungselement (5) aus Kunststoff gebildet ist, an dem Gehäuse (1) entlang geführt wird, und dass der Schaltungsträger (3) vor dem Verschweißen von der Wasserseite in eine Öffnung eingelegt ist und dort auf einem umlaufenden Absatz aufliegt.

2. Elektrisches Gerät nach Anspruch 1, **dadurch gekennzeichnet, dass** sowohl das Gehäuse (1) als auch der Schaltungsträger (3) aus dem gleichen Metall bestehen.

3. Elektrisches Gerät nach Anspruch 1, **dadurch gekennzeichnet, dass** sowohl das Gehäuse (1) als auch der Schaltungsträger (3) aus verschiedenen Metallen bestehen und durch eine Schutzschicht vor Korrosion geschützt sind.

4. Elektrisches Gerät nach Anspruch 1, **dadurch gekennzeichnet, dass** sowohl das Gehäuse als auch der Schaltungsträger (3) aus verschiedenen Metallen bestehen und durch ein elektrisch nicht leitfähiges Kühlmittel vor Korrosion geschützt sind.

5. Verfahren zur Herstellung eines elektrischen Geräts nach einem der Ansprüche 1 bis 4, wobei der Schaltungsträger (3) mit dem übrigen Gehäuse (1) mittels eines Rührreibschweißverfahrens fluiddicht verbunden wird, **dadurch gekennzeichnet, dass** der Schaltungsträger (3) vor der Durchführung des Rührreibschweißverfahrens mit den elektronischen Bauelementen (2) bestückt wird, und dass durch eine Abstützung mit einer guten Wärmeleitung die Prozesswärme des Rührreibschweißverfahrens abseits der Schweißnaht schnell abgeführt wird.

## Claims

1. Electrical device having power electronics which are accommodated in a metal housing (1), components of the power electronics (2) being arranged on a first main surface (3') of a circuit carrier, comprising a metallic base plate and at least one layer of structured conductive material on a dielectric, at least one partition (1') of the housing (1) being in direct contact with a fluid cooling medium, wherein the partition wall (1') of the housing (1) is at least partially formed by the circuit carrier (3) so that its second main surface (3") opposite the component side (3') is in direct contact with the fluid cooling medium, and wherein the circuit carrier (3) is connected to the rest of the housing (1) in a fluid-tight manner by a welded joint (4), **characterised in that** the cooling medium is water, which is guided along the housing (1) through a cooling channel formed by a plastic water guide element (5) arranged between the partition (1') of the housing (1) and a cover, and **in that** the circuit carrier (3) is inserted from the water side into an opening before welding and rests there on a circumferential shoulder.

2. Electrical device according to claim 1, **characterised in that** both the housing (1) and the circuit carrier (3) consist of the same metal.

3. Electrical device according to claim 1, **characterised in that** both the housing (1) and the circuit carrier (3) consist of different metals and are protected against corrosion by a protective layer.

4. Electrical device according to claim 1, **characterised in that** both the housing and the circuit carrier (3) consist of different metals and are protected against corrosion by an electrically non-conductive coolant.

5. Method of manufacturing an electrical device according to any one of claims 1 to 4, wherein the circuit carrier (3) is connected to the rest of the housing (1) in a fluid-tight manner by means of a friction stir welding process, **characterised in that** the circuit carrier (3) is equipped with the electronic components (2) before the friction stir welding process is carried out, and **in that** the process heat of the friction stir welding process is rapidly dissipated away from the weld seam by means of a support with good thermal conduction.

## Revendications

1. Appareil électrique avec une électronique de puissance, qui est logée dans un boîtier métallique (1), des composants de l'électronique de puissance (2) étant disposés sur une première surface principale (3') d'un support de circuit, constitué d'une plaque de base métallique et d'au moins une couche de matériau conducteur structuré sur un diélectrique, au moins une paroi de séparation (1') du boîtier (1) étant en contact direct avec un milieu de refroidissement fluide, la paroi de séparation (1') du boîtier (1) étant formée au moins partiellement par le support de circuit (3), de sorte que sa deuxième surface principale (3"), opposée au côté de composant (3'), est en contact direct avec le milieu de refroidissement fluide, et le support de circuit (3) étant relié de manière étanche aux fluides au reste du boîtier (1) par une liaison soudée (4), **caractérisé en ce que** le fluide de refroidissement est de l'eau qui est guidée le long du boîtier (1) par un canal de refroidissement qui est formé par un élément de guidage d'eau (5) en matière plastique disposé entre la paroi de séparation (1') du boîtier (1) et un couvercle, et **en ce que** le support de circuit (3) est inséré dans une ouverture avant le soudage depuis le côté eau et y repose sur un épaulement périphérique.

2. Appareil électrique selon la revendication 1, **caractérisé en ce qu'**aussi bien le boîtier (1) que le support de circuit (3) sont constitués du même métal.

3. Appareil électrique selon la revendication 1, **caractérisé en ce qu'**aussi bien le boîtier (1) que le support de circuit (3) sont constitués de métaux différents et sont protégés contre la corrosion par une couche de protection.

4. Appareil électrique selon la revendication 1, **caractérisé en ce qu'**aussi bien le boîtier que le support de circuit (3) sont constitués de métaux différents et sont protégés contre la corrosion par un agent de refroidissement non conducteur de l'électricité.

5. Procédé de fabrication d'un appareil électrique selon l'une des revendications 1 à 4, dans lequel le support de circuit (3) est relié de manière étanche aux liquides au reste du boîtier (1) au moyen d'un procédé de soudage par friction-malaxage, **caractérisé en ce que** le support de circuit (3) est équipé des composants électroniques (2) avant la mise en oeuvre du procédé de soudage par friction-malaxage et **en ce que** la chaleur de processus du procédé de soudage par friction-malaxage est rapidement évacuée du cordon de soudure au moyen d'un support bon conducteur de chaleur.
